# EUROPÄISCHE PATENTSCHRIFT

(11) **EP 2 244 373 B1**
(45) Veröffentlichungstag und Bekanntmachung des Hinweises auf die Patenterteilung: **11.06.2014**
(21) Anmeldenummer: 10003755.5
(22) Anmeldetag: 08.04.2010
(51) Int. Cl.: H02P 9/10, F03D 9/00, G01R 31/34, F03D 7/02, F03D 11/00, H01H 83/04

(54) **Verfahren und elektrische Schaltung zum Testen eines an ein elektrisches Energieversorgungsnetz anschliessbaren Energieerzeugers oder Energieverbrauchers**
Method and electric circuit for testing an energy generator or energy consumer which can be connected to an electrical energy supply network
Procédé et circuit électrique destinés à tester un générateur d'énergie ou un consommateur d'énergie pouvant être raccordé à un réseau d'alimentation en énergie électrique

(30) Priorität: 23.04.2009 DE 102009018377
(43) Veröffentlichungstag der Anmeldung: 27.10.2010
(73) Patentinhaber: GE Energy Power Conversion GmbH, 12277 Berlin (DE)
(72) Erfinder: Saniter, Christoph, Dr., 14169 Berlin (DE); Janning, Jörg, Dr., 12559 Berlin (DE)
(74) Vertreter: Serjeants LLP

(56) Entgegenhaltungen:
- EP-A2- 1 995 456
- WO-A1-2008/125718
- DE-C1- 19 853 464
- GB-A- 1 351 563
- US-A1- 2003 227 172
- US-B1- 6 900 972
- IOV F ET AL: "Grid Code Compliance of Grid-Side Converter in Wind Turbine Systems", POWER ELECTRONICS SPECIALISTS CONFERENCE, 2006. PESC '06. 37TH IEEE JEJU, KOREA 18-22 JUNE 2006, PISCATAWAY, NJ, USA,IEEE, 18. Juni 2006 (2006-06-18), Seiten 1-7, XP010945038, DOI: 10.1109/PESC.2006.1711744 ISBN: 978-0-7803-9716-3

## Beschreibung

Die Erfindung betrifft ganz allgemein ein Verfahren und eine elektrische Schaltung zum Testen eines an ein elektrisches Energieversorgungsnetz anschließbaren Energieerzeugers oder Energieverbrauchers. Bei den Energieerzeugern und Energieverbrauchern kann es sich um Generatoren, Motoren, Brennstoffzellen, Solar-Wechselrichter, sogenannte Power Conditioning Systeme oder sonstige elektrische Komponenten handeln, die an ein Energieversorgungsnetz angeschlossen werden können.

Insbesondere betrifft die Erfindung ein Verfahren und eine elektrische Schaltung zum Testen eines Generators einer Windkraftanlage. Es versteht sich, dass die Erfindung auch bei einem Wasserkraftwerk oder bei einem Gasheizkraftwerk oder dergleichen zur Anwendung kommen kann.

Zur Erzeugung elektrischer Energie sind Windkraftanlagen bekannt, bei denen ein Generator mit Hilfe eines dem Wind ausgesetzten Windrads angetrieben wird. Die erzeugte elektrische Energie wird dann in ein Energieversorgungsnetz eingespeist.

Von den Betreibern der Energieversorgungsnetze sind Bedingungen aufgestellt worden, die eine Windkraftanlage erfüllen muss, damit sie an das Energieversorgungsnetz angeschlossen werden darf. Eine sogenannte fault-ride-through-Bedingung macht es dabei erforderlich, dass die Windkraftanlage auch im Falle eines Kurzschlusses des Energieversorgungsnetzes weiterhin in der Lage ist, elektrische Energie in das Energieversorgungsnetz einzuspeisen. In diesem Fall bricht die Spannung am Anschlusspunkt der Windkraftanlage auf eine Teilspannung oder gar auf Null ein.

Es ist bekannt, dass diejenigen elektrischen Bauteile, die der Erzeugung elektrischer Energie dienen, also insbesondere der Generator und gegebenenfalls zugehörige Umrichter, separat, also unabhängig von der Windkraftanlage, mit Hilfe von elektrischen Simulationsschaltungen geprüft werden. Beispielsweise kann eine Windsimulation mit Hilfe eines Elektromotors realisiert sein, mit der ein erwünschter Wind simuliert wird, und die dann auf den Generator einwirkt. Weiterhin kann eine Netzsimulation vorhanden sein, die ein Energieversorgungsnetz simuliert, in das der Generator die erzeugte elektrische Energie einspeist. Diese Netzsimulation ist elektrisch mit dem Generator oder den zugehörigen Umrichtern verbunden. Die Netzsimulation kann derart beeinflusst werden, dass ein erwünschter Spannungsverlauf des Energieversorgungsnetzes mit einer einstellbaren Frequenz erzeugt und dem Generator vorgegeben werden kann.

Die bekannten Verfahren und elektrischen Schaltungen sind in der Lage, einen Spannungseinbruch auf Null, also einen Kurzschluss des Energieversorgungsnetzes zu simulieren. Der Spannungseinbruch kann aber nur in fest vorgegebenen Stufen und mit einer festen Frequenz erfolgen, z.B. in WO 2008125718..

Der Erfindung ist damit die Aufgabe gestellt, ein Verfahren und eine elektrische Schaltung zu schaffen, mit denen beliebige Spannungsverläufe mit beliebigen Frequenzen frei eingestellt werden können.

Die Erfindung löst diese Aufgabe durch das Verfahren nach Anspruch 1. Die Erfindung löst diese Aufgabe ebenfalls durch die elektrische Schaltung nach Anspruch 5.

Bei der Erfindung ist der Energieerzeuger oder Energieverbraucher an einen Anschlusspunkt angeschlossen. Es ist eine Umrichterschaltung vorhanden, mit der eine an dem Anschlusspunkt anliegende Spannung beeinflussbar ist. Es ist eine Serienschaltung vorhanden, die aus einer Drosselspule und einem ersten Schalter aufgebaut ist, und die mit dem Anschlusspunkt gekoppelt ist. In zeitlich aufeinander abgestimmter Weise wird einerseits die Umrichterschaltung derart beeinflusst, dass die Spannung an dem Anschlusspunkt auf einen erwünschten Wert übergeht, und andererseits wird der erste Schalter geschlossen.

Der Einbruch oder Kurzschluss des simulierten Energieversorgungsnetzes wird also durch das Zusammenspiel zweier Maßnahmen erzeugt, nämlich durch die Verminderung der genannten Spannung mit Hilfe der Umrichterschaltung einerseits, sowie durch das Schließen des ersten Schalters andererseits. Diese Vorgehensweise bringt den Vorteil mit sich, dass ohne einen wesentlichen zusätzlichen Aufwand ein simulierter Einbruch oder Kurzschluss auf einfache Weise erreicht werden kann. Dabei ist im Hinblick auf den Umrichter eine geringere Überlastbarkeit als beim Stand der Technik ausreichend, da der Stromfluss kleiner ist in demjenigen Fall, in dem der erste Schalter nicht geschlossen wird. Das Testen des Energieerzeugers oder Energieverbrauchers kann auf diese Weise wesentlich vereinfacht und damit verbessert werden.

Bei einer Ausgestaltung der Erfindung ist eine Parallelschaltung vorhanden, die aus einer Drosselspule und einem zweiten Schalter aufgebaut ist, und die zwischen die Umrichterschaltung und den Anschlusspunkt geschaltet ist, und es wird der zweite Schalter in zeitlich abgestimmter Weise mit der Umrichterschaltung und dem ersten Schalter geöffnet. Mit Hilfe der zusätzlichen Drosselspule ist es möglich, den Übergang der an dem Anschlusspunkt vorhandenen Spannung zu dem erwünschten Wert zu beeinflussen. Insbesondere ist es möglich, die sogenannte "Härte" des simulierten Energieversorgungsnetzes zu verändern.

In entsprechender Weise ist erfindungsgemäß vorgesehen, den ersten Schalter zu öffnen. Damit wird der simulierte Einbruch oder Kurzschluss des Energieversorgungsnetzes beendet. Die dabei auftretende Spannungsänderung kann wiederum mit Hilfe der Umrichterschaltung beeinflusst werden.

Bei einer Weiterbildung der Erfindung ist/sind der/die Schalter als elektronische/s Leistungshalbleiterbauelement/e ausgebildet, beispielsweise als Thyristor mit oder ohne zugehörige Löschschaltung oder als GTO-Thyristor (GTO = gate-turn-off) oder als ausschaltbarer IGBT (IGBT = insulated gate bipolar transistor). Dies bringt den Vorteil mit sich, dass der Zeitpunkt der Betätigung des/der Schalter besonders einfach und genau kontrolliert werden kann. Insbesondere kann der Einsatz von Thyristoren ohne Löschschaltung vorteilhaft sein, da diese das Verhalten eines Mittelspannungsschalters relativ realistisch nachbilden.

Bei einer anderen Weiterbildung der Erfindung ist/sind die Induktivität/en der Drosselspule/n einstellbar. Damit können gleichartige Spannungseinbrüche bei unterschiedlichen Frequenzen des simulierten Energieversorgungsnetzes erreicht werden.

Weitere Merkmale, Anwendungsmöglichkeiten und Vorteile der Erfindung ergeben sich aus der nachfolgenden Beschreibung von Ausführungsbeispielen der Erfindung, die in den Figuren der Zeichnung dargestellt sind. Dabei bilden alle beschriebenen oder dargestellten Merkmale für sich oder in beliebiger Kombination den Gegenstand der Erfindung, unabhängig von ihrer Zusammenfassung in den Patentansprüchen oder deren Rückbeziehung sowie unabhängig von ihrer Formulierung bzw. Darstellung in der Beschreibung bzw. in der Zeichnung.

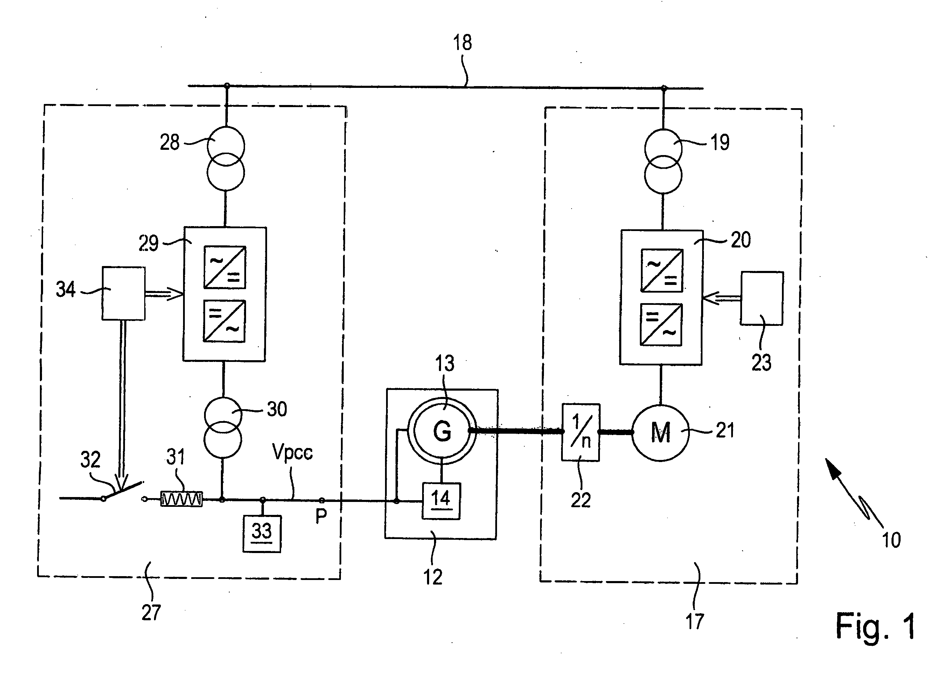

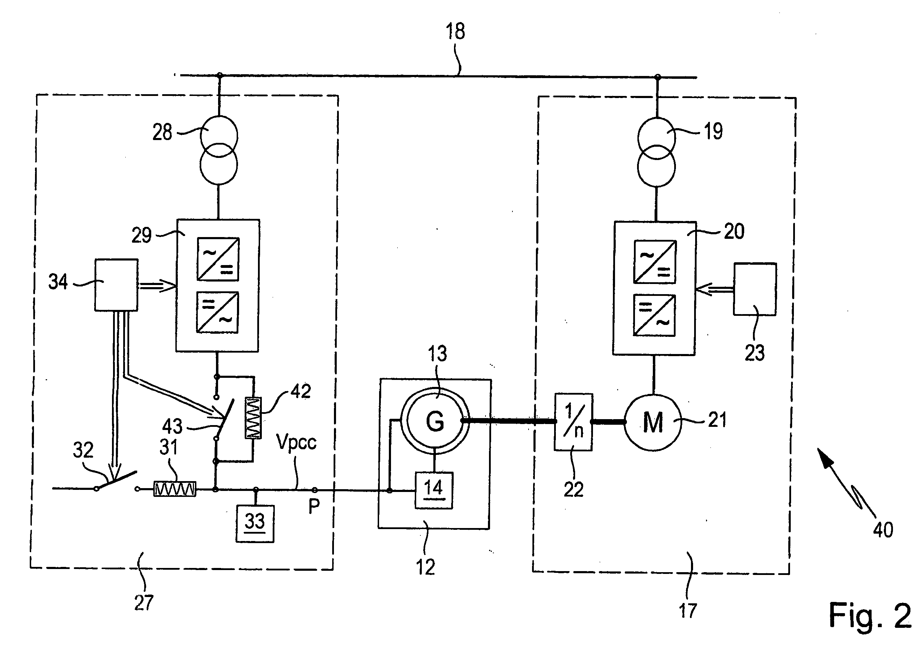

Figur 1 zeigt ein schematisches Blockschaltbild eines ersten Ausführungsbeispiels einer erfindungsgemäßen elektrischen Schaltung zum Testen eines Generators insbesondere einer Windkraftanlage, und Figur 2 zeigt ein schematisches Blockschaltbild eines zweiten Ausführungsbeispiels einer entsprechenden elektrischen Schaltung.

In der Figur 1 ist eine elektrische Schaltung 10 dargestellt, die im vorliegenden Ausführungsbeispiel im Zusammenhang mit einer Windkraftanlage zum Einsatz kommt. Es versteht sich, dass die Schaltung 10 auch bei einem Wasserkraftwerk oder bei einem Gasheizkraftwerk oder dergleichen zur Anwendung kommen kann. Weiterhin ist die Schaltung 10 im vorliegenden Ausführungsbeispiel zum Testen eines Generators vorgesehen. Es versteht sich, dass auch andere Energieerzeuger oder Energieverbraucher mit der Schaltung 10 getestet werden können, beispielsweise können auch ein Elektromotor oder eine Brennstoffzelle oder ein Solar-Wechselrichter oder ein sogenanntes Power Conditioning System oder dergleichen getestet werden.

Die Schaltung 10 ist in der Figur 1 zum Zwecke der Vereinfachung im wesentlichen nur einphasig dargestellt. Es versteht sich, dass die Schaltung 10 auch zwei- und mehrphasig ausgebildet sein kann.

Die Schaltung 10 weist eine Generatorschaltung 12 auf, die getestet werden soll. Bei der Generatorschaltung 12 handelt es sich um diejenigen Bauteile der Windkraftanlage, die der Erzeugung elektrischer Energie dienen. Im vorliegenden Ausführungsbeispiel ist die Generatorschaltung 12 beispielhaft aus einem doppelt-gespeisten Asynchrongenerator 13 mit zugehörigen Umrichtern 14 aufgebaut. Der Rotor des Asynchrongenerators 13 ist über die Umrichter mit einem Anschlusspunkt der Generatorschaltung 12 verbunden und der Stator des Asynchrongenerators 13 ist direkt mit diesem Anschlusspunkt verbunden. Es versteht sich, dass auch andere Generator-Typen zur Anwendung kommen können, beispielsweise Synchrongeneratoren, und/oder dass auch keine Umrichter vorhanden sein können.

Die Schaltung 10 weist eine Windsimulation 17 auf, die im vorliegenden Ausführungsbeispiel den den Asynchrongenerator 13 antreibenden Wind simulieren soll. Die Windsimulation 17 ist aus einem an ein Energieversorgungsnetz 18 angeschlossenen Transformator 19, einer Umrichterschaltung 20 und einem Elektromotor 21 aufgebaut. Die Antriebswelle des Elektromotors 21 ist über ein gegebenenfalls zwischengeschaltetes Getriebe 22 drehfest mit der Antriebswelle des Generators 13 verbunden.

Mit Hilfe einer Steuerung und/oder Regelung 23 kann die Umrichterschaltung 20 derart über der Zeit beeinflusst werden, dass der resultierende Drehzahlverlauf des Elektromotors 21 einem erwünschten, den Asynchrongenerator 13 antreibenden Wind entspricht.

Die elektrische Schaltung 10 muss örtlich nicht direkt bei der Windkraftanlage aufgebaut sein, sondern kann unabhängig von der Windkraftanlage beispielsweise in einer Versuchshalle untergebracht sein. Es versteht sich aber, dass die Schaltung 10 auch direkt bei der Windkraftanlage vorhanden sein kann. Ist in diesem Fall die Generatorschaltung 12 in die Windkraftanlage eingebaut, ist also insbesondere der Asynchrongenerator 13 drehfest mit dem Windrad der Windkraftanlage verbunden, so kann die Windsimulation 17 ersatzlos entfallen.

Die elektrische Schaltung 10 weist eine Netzsimulation 27 auf, die den zeitlichen Spannungsverlauf eines simulierten Energieversorgungsnetzes simulieren soll. In dieses simulierte Energieversorgungsnetz speist die Generatorschaltung 12 elektrische Energie ein. Die Netzsimulation 27 ist aus einem an das Energieversorgungsnetz 18 angeschlossenen Transformator 28, einer Umrichterschaltung 29 und einem gegebenenfalls vorgesehenen, weiteren Transformator 30 aufgebaut. Die Umrichterschaltung 29 ist über den weiteren Transformator 30 mit der Generatorschaltung 12 verbunden, im vorliegenden Ausführungsbeispiel mit dem erwähnten Anschlusspunkt der Generatorschaltung 12. Ausgehend von diesem Anschlusspunkt der Generatorschaltung 12 ist auf der Verbindung zu dem Transformator 30 ein weiterer Anschlusspunkt P vorhanden, an dem eine Spannung Vpcc anliegt (pcc = point of common coupling).

Alternativ ist es möglich, dass zwischen den beiden Umrichterschaltungen 20, 29 der Windsimulation 17 und der Netzsimulation 27 eine gemeinsame Gleichspannungsschiene vorhanden ist. In diesem Fall ist nur ein einziger netzseitiger Umrichter und nur ein einziger Transformator in Richtung zu dem Energieversorgungsnetz 18 hin erforderlich.

An den Anschlusspunkt P ist eine Serienschaltung einer Drosselspule 31 und eines ersten Schalters 32 angeschlossen. Die Reihenfolge innerhalb der Serienschaltung ist dabei unerheblich, so dass auch der Schalter 32 an den Anschlusspunkt P angeschlossen sein kann. Die Serienschaltung kann an einen Sternpunkt mehrerer Phasen angeschlossen sein. Ebenfalls ist es möglich, dass die Serienschaltung ein Bestandteil einer Dreieckschaltung mehrerer Phasen ist. Gegebenenfalls kann die Serienschaltung auch nach Masse geschaltet sein.

Weiterhin ist an den Anschlusspunkt P eine Filterschaltung 33 angeschlossen.

Die Induktivität der Drosselspule 31 ist veränderbar. Dies kann beispielsweise dadurch erreicht werden, dass die Anzahl der Windungen der Drosselspule 31 mittels mechanischer Vorrichtungen manuell einstellbar ist. Mit Hilfe entsprechender Einstellungen der Drosselspule 31 können im wesentlichen gleichartige Verläufe des simulierten Energieversorgungsnetzes erzeugt werden, und zwar unabhängig von der Frequenz des simulierten Energieversorgungsnetzes.

Der erste Schalter 32 ist als elektronisches Leistungshalbleiterbauelement ausgebildet. Beispielsweise kann es sich bei dem Schalter 32 um einen Thyristor mit oder ohne zugehörige Löschschaltung oder um einen GTO-Thyristor (GTO = gate-turn-off) oder um einen ausschaltbaren IGBT (IGBT = insulated gate bipolar transistor) oder dergleichen handeln, wobei diese Bauelemente vorzugsweise als Module aufgebaut sein können und damit beispielsweise Freilaufdioden und dergleichen bereits enthalten können.

Bei der Filterschaltung 33 kann es sich um bekannte elektrische Schaltungen handeln, mit deren Hilfe die Spannung Vpcc geglättet werden kann.

Mit Hilfe einer Steuerung und/oder Regelung 34 kann die Umrichterschaltung 29 derart über der Zeit beeinflusst werden, dass der resultierende zeitliche Verlauf der Spannung Vpcc einem erwünschten vorgegebenen Spannungsverlauf eines Energieversorgungsnetzes entspricht. Die vorgegebenen Spannungsverläufe können dabei symmetrisch oder asymmetrisch eingestellt sein. Es können auch unterschiedliche Frequenzen des simulierten Energieversorgungsnetzes mittels der Umrichterschaltung 29 frei eingestellt werden, insbesondere 50 Hertz und 60 Hertz.

Weiterhin ist die Steuerung und/oder Regelung 34 dazu vorgesehen, den Schalter 32 von einem geschlossenen in einen geöffneten Zustand und umgekehrt zu schalten. Nachfolgend wird davon ausgegangen, dass sich der Schalter 32 in seinem geöffneten Zustand befindet und die Drosselspule 31 damit nicht wirksam ist.

Insgesamt kann eine zu testende Generatorschaltung 12 mittels der Windsimulation 17 einem erwünschten Wind und mittels der Netzsimulation 27 einem vorgegebenen Spannungsverlauf des gespeisten Energieversorgungsnetzes ausgesetzt werden. Die elektrische Schaltung 10 ist damit unter anderem dazu geeignet, das Verhalten der Generatorschaltung 12 bei einem einphasigen oder mehrphasigen Einbruch des gespeisten Energieversorgungsnetzes auf eine vorgegebene Spannung oder gar auf Null und damit bei einem ein- oder mehrphasigen Kurzschluss zu testen.

Zur Simulation eines Einbruchs oder eines Kurzschlusses des gespeisten Energieversorgungsnetzes werden von der Netzsimulation 27 zwei Maßnahmen in zeitlich aufeinander abgestimmter Weise durchgeführt. Einerseits wird die Umrichterschaltung 29 derart beeinflusst, dass die Spannung Vpcc möglichst schnell auf die erwünschte vorgegebene Spannung oder auf Null übergeht. Und andererseits wird der erste Schalter 32 in seinen geschlossenen Zustand geschaltet, so dass die Spannung Vpcc über der Drosselspule 31 anliegt. Die beiden Maßnahmen müssen nicht gleichzeitig durchgeführt werden, sondern laufen in einem weitgehend zusammenfallenden Zeitbereich ab. Die Reihenfolge der beiden genannten Maßnahmen steht dabei nicht im Vordergrund. Wesentlich ist die zeitliche Abstimmung der beiden Maßnahmen derart zueinander, dass der Übergang zu dem angestrebten Einbruch oder Kurzschluss des simulierten und von der Generatorschaltung 12 gespeisten Energieversorgungsnetzes den erwünschten Verlauf hat. Beispielsweise werden die beiden Maßnahmen derart zueinander synchronisiert, dass die Spannung Vpcc zuerst mit Hilfe der Umrichterschaltung 29 vermindert wird und danach durch Schließen des Schalters 32 von dem Spannungsabfall über der Drosselspule 31 bestimmt wird.

Durch diese Maßnahmen kann - wie erwähnt - ein Einbruch auf eine vorgegebene Spannung oder ein Kurzschluss in demjenigen Energieversorgungsnetz simuliert werden, in das die Generatorschaltung 12 elektrische Energie einspeist. Es kann damit getestet werden, wie sich die Generatorschaltung 12 in einem derartigen Fall verhält. Insbesondere kann geprüft werden, ob die Generatorschaltung 12 sogenannte fault-ride-through-Bedingungen erfüllt.

Derartige fault-ride-through-Bedingungen werden von den Betreibern von Energieversorgungsnetzen vorgegeben. Nach diesen Bedingungen muss beispielsweise eine an ein Energieversorgungsnetz angeschlossene Windkraftanlage auch im Fall eines Netz-Kurzschlusses in der Lage sein, fortlaufend Wirk- und Blindleistung in das Energieversorgungsnetz einzuspeisen.

Zur Beendigung des simulierten Einbruchs oder Kurzschlusses in dem Energieversorgungsnetz werden die beiden erläuterten Maßnahmen von der Netzsimulation 27 wieder rückgängig gemacht. Auch hier kommt es nicht auf die Gleichzeitigkeit oder die Reihenfolge der Maßnahmen an, sondern auf deren zeitliche Abstimmung zueinander. Beispielsweise wird zuerst der erste Schalter 32 in seinen geöffneten Zustand geschaltet und danach die Umrichterschaltung 29 derart beeinflusst, dass die Spannung Vpcc wieder auf einen erwünschten Wert ansteigt.

In der Figur 2 ist eine elektrische Schaltung 40 dargestellt, die auf der Schaltung 10 der Figur 1 aufgebaut ist. In Ergänzung zur Schaltung 10 der Figur 1 enthält die Schaltung 40 der Figur 2 eine Parallelschaltung einer Drosselspule 42 und eines zweiten Schalters 43. Im Unterschied zur Schaltung 10 der Figur 1 enthält die Schaltung 40 der Figur 2 jedoch keinen weiteren Transformator 30. Es wird jedoch ausdrücklich darauf hingewiesen, dass dieser weitere Transformator 30 auch bei der Schaltung 40 der Figur 2 vorhanden sein kann.

Die Parallelschaltung ist zwischen die Umrichterschaltung 29 und den Anschlusspunkt P geschaltet. Sofern der weitere Transformator 30 vorhanden ist, dann ist die Parallelschaltung zwischen diesen weiteren Transformator 30 und den Anschlusspunkt P geschaltet.

Im Hinblick auf die mit der Schaltung 10 übereinstimmenden Bauteile der Schaltung 40 wird auf die vorstehende Erläuterung der Figur 1 verwiesen. Nachfolgend werden nur diejenigen Bauteile und Funktionen der Schaltung 40 der Figur 2 näher erläutert, die sich von der Schaltung 10 der Figur 1 unterscheiden.

Die Induktivität der Drosselspule 42 ist veränderbar. Dies kann beispielsweise dadurch erreicht werden, dass die Anzahl der Windungen der Drosselspule 42 mittels mechanischer Vorrichtungen manuell einstellbar ist.

Der zweite Schalter 43 ist als elektronisches Leistungshalbleiterbauelement ausgebildet. Beispielsweise kann es sich bei dem Schalter 43 um einen Thyristor mit einer zugehörigen Löschschaltung oder um einen GTO-Thyristor (GTO = gate-turn-off) oder um einen ausschaltbaren IGBT (IGBT = insulated gate bipolar transistor) oder dergleichen handeln, wobei diese Bauelemente vorzugsweise als Module aufgebaut sein können und damit beispielsweise Freilaufdioden und dergleichen bereits enthalten können.

Weiterhin ist die Steuerung und/oder Regelung 34 dazu vorgesehen, den zweiten Schalter 43 von einem geschlossenen in einen geöffneten Zustand und umgekehrt zu schalten. Nachfolgend wird davon ausgegangen, dass der Schalter 32 sich in seinem geöffneten Zustand und der Schalter 43 sich in seinem geschlossenen Zustand befindet. Damit sind beide Drosselspulen 31, 42 unwirksam.

Zur Simulation eines Einbruchs oder Kurzschlusses eines Energieversorgungsnetzes werden von der Windsimulation 27 drei Maßnahmen in zeitlich aufeinander abgestimmter Weise durchgeführt. So wird einerseits der zweite Schalter 43 geöffnet und andererseits die Umrichterschaltung 29 derart beeinflusst, dass die Spannung Vpcc möglichst schnell auf die erwünschte vorgegebene Spannung oder auf Null übergeht. Weiterhin wird der erste Schalter 32 in seinen geschlossenen Zustand geschaltet, so dass die Spannung Vpcc über der Drosselspule 31 abfällt. Die drei Maßnahmen müssen nicht gleichzeitig durchgeführt werden, sondern laufen in einem weitgehend zusammenfallenden Zeitbereich ab. Die Reihenfolge der genannten Maßnahmen steht dabei nicht im Vordergrund. Wesentlich ist die zeitliche Abstimmung der drei Maßnahmen derart zueinander, dass der Übergang zu dem angestrebten Einbruch oder Kurzschluss des simulierten und von der Generatorschaltung 12 gespeisten Energieversorgungsnetzes den erwünschten Verlauf hat.

Beispielsweise werden die drei Maßnahmen derart zueinander synchronisiert, dass zuerst der zweite Schalter 43 geöffnet wird, um danach die Spannung Vpcc mit Hilfe der Umrichterschaltung 29 zu vermindern und schließlich diese Spannung Vpcc durch Schließen des ersten Schalters 32 über der Drosselspule 31 abfallen zu lassen. Zumindest werden die drei Maßnahmen derart zeitlich abgestimmt, dass das Schließen des Schalters 43 in einem Zeitraum erfolgt, bevor ein Einbruch oder Kurzschluss der Spannung Vpcc simuliert wird.

Durch diese Maßnahmen kann - wie erwähnt - ein Einbruch oder ein Kurzschluss in demjenigen Energieversorgungsnetz simuliert werden, in das die Generatorschaltung 12 elektrische Energie einspeist. Es kann damit getestet werden, wie sich die Generatorschaltung 12 in diesen Fällen verhält. Insbesondere kann geprüft werden, ob die Generatorschaltung 12 die bereits erwähnten fault-ride-through-Bedingungen erfüllt.

Zur Beendigung des simulierten Einbruchs oder Kurzschlusses in dem Energieversorgungsnetz werden die drei erläuterten Maßnahmen von der Netzsimulation 27 rückgängig gemacht. Auch hier kommt es nicht auf die Gleichzeitigkeit oder die Reihenfolge der Maßnahmen an, sondern auf deren zeitlichen Abstimmung zueinander. Beispielsweise wird zuerst der erste Schalter 32 in seinen geöffneten Zustand geschaltet, um danach die Umrichterschaltung 29 derart zu beeinflussen, dass die Spannung Vpcc wieder auf einen erwünschten Wert ansteigt. Schließlich wird der zweite Schalter 43 wieder geschlossen.

## Patentansprüche

1. Verfahren zum Testen eines an ein elektrisches Energieversorgungsnetz anschließbaren Energieerzeugers oder Energieverbrauchers, wobei der Energieerzeuger oder Energieverbraucher an einen Anschlusspunkt (P) angeschlossen ist, und wobei eine Umrichterschaltung (29) vorhanden ist, mit der eine an dem Anschlusspunkt (P) anliegende Spannung (Vpcc) beeinflussbar ist, wobei eine Serienschaltung vorhanden ist, die aus einer Drosselspule (31) und einem ersten Schalter (32) aufgebaut ist, und die mit dem Anschlusspunkt (P) gekoppelt ist, **dadurch gekennzeichnet, dass** ein Einbruch oder ein Kurzschluss des Energieversorgungsnetzes simuliert wird, indem in zeitlich aufeinander abgestimmter Weise einerseits die Umrichterschaltung (29) derart beeinflusst wird, dass eine Spannung (Vpcc) an dem Anschlusspunkt (P) auf einen ersten erwünschten Wert übergeht, und andererseits der erste Schalter (32) geschlossen wird, derart, dass der Übergang zu dem angestrebten Einbruch oder Kurzschluss des Energieversorgungsnetzes dem erwünschten Verlauf hat, oder dass ein simulierter Einbruch oder Kurzschluss in dem Energieversorgungsnetz beendet wird, indem in zeitlich aufeinander abgestimmter Weise einerseits die Umrichterschaltung (29) derart beeinflusst wird, dass eine Spannung (Vpcc) an dem Anschlusspunkt (P) auf einen zweiten erwünschten Wert übergeht und andererseits der eine Schalter geöffnet wird.

2. Verfahren nach Anspruch 1, wobei eine Parallelschaltung vorhanden ist, die aus einer Drosselspule (42) und einem zweiten Schalter (43)aufgebaut ist, und die zwischen die Umrichterschaltung (29) und den Anschlusspunkt (P) geschaltet ist, und wobei während eines simulierten Einbruches oder Kurzschlusses in dem Energieversorungsnetz der zweite Schalter (43) in zeitlich abgestimmter Weise mit der Umrichterschaltung (29) und dem Schließen des ersten Schalters (32) geöffnet wird.

3. Verfahren nach Anspruch 2, wobei zuerst der zweite Schalter (43) geöffnet wird, dann die Umrichterschaltung (29) derart beeinflusst wird, dass die Spannung (Vpcc) auf den erwünschten Wert übergeht, und danach der erste Schalter (32) geschlossen wird.

4. Verfahren nach Anspruch 1, wobei eine Parallelschaltung vorhanden ist, die aus einer Drosselspule (42) und einem zweiten Schalter (43) aufgebaut ist, und die zwischen die Umrichterschaltung (29) und den Anschlusspunkt (P) geschaltet ist, und wobei während eines Beendens eines simulierten Einbruchs oder Kurzzschlusses in dem Energievesorgungsnetz der zweite Schalter (43) in zeitlich abgestimmter Weise mit der Umrichterschaltung (29) und dem Öffnen des ersten Schalters (32) geschlossen wird.

5. Elektrische Schaltung (10, 40) zum Testen eines an ein elektrisches Energieversorgungsnetz anschließbaren Energieerzeugers oder Energieverbrauchers, wobei der Energieerzeuger oder Energieverbraucher an einen Anschlusspunkt (P) angeschlossen ist, und wobei eine Umrichterschaltung (29) vorhanden ist, mit der eine an dem Anschlusspunkt (P) anliegende Spannung (Vpcc) beeinflussbar ist, wobei eine Serienschaltung vorhanden ist, die aus einer Drosselspule (31) und einem ersten Schalter (32) aufgebaut ist, und die mit dem Anschlusspunkt (P) gekoppelt ist, **dadurch gekennzeichnet, dass** eine Steuerung und/oder Regelung (34) vorhanden ist, um einen Einbruch oder Kurzschluss in dem Energieversorungsnetz zu simulieren, wobei in zeitlich aufeinander abgestimmter Weise einerseits die Umrichterschaltung (29) derart beeinflusst wird, dass die Spannung (Vpcc) an dem Anschlusspunkt (P) auf einen ersten erwünschten Wert übergeht, und andererseits der erste Schalter (32) geschlossen wird, derart, dass der Übergang zu dem angestrebten Einbruch oder Kurzschluss des Energieversorgungsnetzes dem erwünschten Verlauf hat; oder Beenden eines simulierten Einbruchs oder Kurzschlusses in dem Energieversorgungsnetz, wobei in zeitlich aufeinander abgestimmter Weise einerseits die Umrichterschaltung (29) derart beeinflusst wird, dass die Spannung (Vpcc) an dem Anschlusspunkt (P) auf einen zweiten erwünschten Wert übergeht und der erste Schalter geöffnet wird.

6. Schaltung (40) nach Anspruch 5, wobei eine Parallelschaltung vorhanden ist, die aus einer Drosselspule (42) und einem zweiten Schalter (43) aufgebaut ist, und die zwischen die Umrichterschaltung (29) und den Anschlusspunkt (P) geschaltet ist, und wobei der zweite Schalter (43) von der Steuerung und/oder Regelung (34)während eines simulierten Einbruchs oder Kurzschlusses in dem Energieversorgungsnetz in zeitlich abgestimmter Weise mit der Umrichterschaltung (29) und dem Schließen des ersten Schalters (32) geöffnet wird.

7. Schaltung (40) nach Anspruch 5, wobei eine Parallelschaltung vorhanden ist, die aus einer Drosselspule (42) und einem zweiten Schalter (43) aufgebaut ist, und die zwischen die Umrichterschaltung (29) und den Anschlusspunkt (P) geschaltet ist, und wobei der zweite Schalter (43) von der Steuerung und/oder Regelung (34) während eines Beendens eines simulierten Einbruchs oder Kurzschlussees in dem Energieversorgungsnetz in zeitlich abgestimmter Weise mit der Umrichterschaltung (29) und dem Öffnen des ersten Schalters (32) geschlossen wird.

8. Schaltung (10, 40) nach einem der Ansprüche 5 bis 7, wobei der/die Schalter (32, 43) als elektronische/s Leistungshalbleiterbauelement/e ausgebildet ist/sind, beispielsweise als Thyristor mit oder ohne zugehörige Löschschaltung oder als GTO-Thyristor (GTO =gate-turn-off) oder als ausschaltbarer IGBT (IGBT = insulated gate bipolar transistor).

9. Schaltung (10, 40) nach einem der Ansprüche 5 bis 8, wobei die Induktivität/en der Drosselspule/n (31, 42) einstellbar sind.

10. Schaltung (10, 40) nach einem der Ansprüche 5 bis 9, wobei eine Filterschaltung (33) vorhanden ist, die mit dem Anschlusspunkt (P) verbunden ist.

11. Schaltung (10, 40) nach einem der Ansprüche 5 bis 10, wobei als Energieerzeuger ein Asynchrongenerator (13) oder ein Synchrongenerator gegebenenfalls mit zugehörigen Umrichtern (14) vorgesehen ist.

12. Schaltung (10, 40) nach einem der Ansprüche 5 bis 11, wobei der Energieerzeuger zur Verwendung in einer Windkraftanlage vorgesehen ist.

13. Schaltung (10, 40) nach Anspruch 12, wobei eine Windsimulation (17) vorhanden ist, die einen Elektromotor (21) aufweist, der drehfest mit dem Energieerzeuger gekoppelt ist.

14. Schaltung (10, 40) nach Anspruch 13, wobei der Energieerzeuger noch nicht in die Windkraftanlage eingebaut ist.

## Claims

1. Method for testing an energy generator or energy consumer which can be connected to an electrical energy supply network, wherein the energy generator or the energy consumer is connected to a connection point (P), and wherein a converter circuit (29) is provided, with the use of which converter circuit it is possible to influence a voltage (Vpcc) applied to said connection point, wherein a series circuit is provided, said series circuit comprising a choke coil (31) and a first switch (32) and being coupled with the connection point (P), **characterized in that** a collapse or a short circuit of the energy supply network is simulated **in that**, in a time-coordinated manner, on the one hand, the converter circuit (29) is affected in such a manner that a voltage (Vpcc) at the connection point (P) is converted to a first desired value and that, on the other hand, the first switch (32) is closed in such a manner that the transition to the aimed at collapse or short circuit of the energy supply network exhibits the desired course or that a simulated collapse or short circuit in the energy supply network is ended **in that**, on the one hand, in a time-coordinated manner, the converter circuit (29) is affected in such a manner that a voltage (Vpcc) at the connection point (P) converts to a second desirable value and that, on the other hand, the one switch is being opened.

2. Method as in Claim 1, wherein a parallel circuit is provided, said parallel circuit comprising a choke coil (42) and a second switch (43) and being interposed between the converter circuit (29) and the connection point (P), and wherein, during a simulated collapse or short circuit in the energy supply network, the second switch (43) is opened in a time-coordinated manner with the converter circuit (29) and the closing of the first switch (32).

3. Method as in Claim 2, wherein the first switch (43) is opened, and then the converter circuit (29) is affected in such a manner that the voltage (Vpcc) converts to the desired value, and that, thereafter, the first switch (32) is closed.

4. Method as in Claim 1, wherein a parallel circuit is provided, said circuit comprising a choke coil (42) and a second switch (43) and being interposed between the converter circuit (29) and the connection point (P), and wherein, while a simulated collapse or short circuit in the energy supply network is ended, the second switch (43) is closed in a time-coordinated manner with the converter circuit (29) and the opening of the first circuit (32).

5. Electric circuit (10, 40) for testing an energy generator or energy consumer which can be connected to an electrical supply network, wherein the energy generator or the energy consumer is connected to a connection point (P), and wherein a converter circuit (29) is provided, with the use of which converter circuit it is possible to influence a voltage (Vpcc) applied to the connection point (P), wherein a series circuit is provided, said series circuit comprising a choke coil (31) and a first switch (32) and being coupled with the connection point (P), **characterized in that** a controller and or regulator (34) is provided in order to simulate a collapse or a short circuit in the energy supply network, wherein, in a time-coordinated manner, on the one hand, the converter circuit (29) is affected in such a manner that the voltage (Vpcc) is converted to a first desired value at the connection point (P) and, on the other hand, the first switch (32) is closed in such a manner that the transition to the aimed at collapse or short circuit of the energy supply network exhibits the desired course; or the ending of a simulated collapse or short circuit in the energy supply network, wherein, in a time-coordinated manner, on the one hand, the converter circuit (29) is affected in such a manner that the voltage (Vpcc) at the connection point (P) converts to a second desirable value and the first switch is being opened.

6. Circuit (40) as in Claim 5, wherein a parallel circuit is provided, said parallel circuit comprising a choke coil (42) and a second switch (43) and being interposed between the converter circuit (29) and the connection point (P), and wherein, during a simulated collapse or short circuit in the energy supply network, the second switch (43) is opened by the controller and/or regulator (34) in a time-coordinated manner with the converter circuit (29) and the closing of the first switch (32).

7. Circuit (40) as in Claim 5, wherein a parallel circuit is provided, said parallel circuit comprising a choke coil (42) and a second switch (43) and being interposed between the converter circuit (29) and the connection point (P), and wherein, while a simulated collapse or short circuit is being ended, the second switch (43) is closed by the controller and/or regulator (34) in a time-coordinated manner with the converter circuit (29) and the opening of the first switch (32).

8. Circuit (10, 40) as in one of the Claims 5 through 7,
wherein the switch(es) (32, 43) are configured as electronic power semi-conductor component(s), for example as a thyristor, with or without an associated quenching circuit, or as a GTO (gate turn-off) thyristor or as an IGBT (insulated gate bipolar transistor) that can be switched off.

9. Circuit (10, 40) as in one of the Claims 5 through 8,
wherein the inductance(s) of the choke coil(s) (31, 42) is (are) adjustable.

10. Circuit (10, 40) as in one of the Claims 5 through 8,
wherein a filter circuit (33) is provided, said filter circuit being connected to the connection point (P).

11. Circuit (10, 40) as in one of the Claims 5 through 10, wherein an asynchronous generator (13) or a synchronous generator, optionally with associate converters (14), is provided as the energy generator.

12. Circuit (10, 40) as in one of the Claims 5 through 11, wherein the energy generator is provided for use in a wind power plant.

13. Circuit (10, 40) as in Claim 12, wherein a wind simulation (17) is provided, comprising an electric motor (21) that is co-rotationally coupled with the energy generator.

14. Circuit (10, 40) as in Claim 13, wherein the energy generator has not yet been installed in the wind power plant.

## Revendications

1. Procédé destiné à tester un générateur d'énergie ou un consommateur d'énergie pouvant être raccordé à un réseau d'alimentation en énergie électrique, selon lequel le générateur d'énergie ou le consommateur d'énergie est raccordé à un point de connexion (P), et un circuit convertisseur (29) est prévu, qui permet d'influencer une tension (Vpcc) appliquée au point de connexion (P), selon lequel il est prévu un montage en série qui est constitué d'une bobine d'inductance (31) et d'un premier interrupteur (32) et qui est couplé au point de connexion (P), **caractérisé en ce qu'**un effondrement ou un court-circuit du réseau d'alimentation en énergie est simulé par le fait que, d'une part, le circuit convertisseur (29) est influencé de façon coordonnée dans le temps, de telle sorte qu'une tension (Vpcc) au point de connexion (P) passe à une première valeur souhaitée, et, d'autre part, le premier interrupteur (32) est fermé, de telle sorte que le passage à l'effondrement ou au court-circuit recherché du réseau d'alimentation en énergie présente l'évolution souhaitée, ou **en ce qu'**il soit mis fin à un effondrement ou un court-circuit simulé dans le réseau d'alimentation en énergie, par le fait que, d'une part, le circuit convertisseur (29) est influencé de façon coordonnée dans le temps, de telle sorte qu'une tension (Vpcc) au point de connexion (P) passe à une deuxième valeur souhaitée et, d'autre part, l'un des interrupteurs est ouvert.

2. Procédé selon la revendication 1, selon lequel il est prévu un montage en parallèle qui est constitué d'une bobine d'inductance (42) et d'un deuxième interrupteur (43) et qui est connecté entre le circuit convertisseur (29) et le point de connexion (P), et selon lequel, au cours d'un effondrement ou d'un court-circuit simulé dans le réseau d'alimentation en énergie, le deuxième interrupteur (43) est ouvert de façon coordonnée dans le temps avec le circuit convertisseur (29) et la fermeture du premier interrupteur (32).

3. Procédé selon la revendication 2, selon lequel on ouvre d'abord le deuxième interrupteur (43) et ensuite on agit sur le circuit convertisseur (29) de manière à ce que la tension (Vpcc) passe à la valeur souhaitée, puis on ferme le premier interrupteur (32).

4. Procédé selon la revendication 1, selon lequel il est prévu un montage en parallèle qui est constitué d'une bobine d'inductance (42) et d'un deuxième interrupteur (43) et qui est connecté entre le circuit convertisseur (29) et le point de connexion (P), et selon lequel, au cours d'un arrêt d'un effondrement ou d'un court-circuit simulé dans le réseau d'alimentation en énergie, le deuxième interrupteur (43) est fermé de façon coordonnée dans le temps avec le circuit convertisseur (29) et l'ouverture du premier interrupteur (32).

5. Circuit électrique (10, 40) destiné à tester un générateur d'énergie ou un consommateur d'énergie pouvant être raccordé à un réseau d'alimentation en énergie électrique, dans lequel le générateur d'énergie ou le consommateur d'énergie est raccordé à un point de connexion (P), et un circuit convertisseur (29) est prévu, qui permet d'influencer une tension (Vpcc) appliquée au point de connexion (P), où il est prévu un montage en série qui est constitué d'une bobine d'inductance (31) et d'un premier interrupteur (32) et qui est couplé au point de connexion (P), **caractérisé en ce qu'**il est prévu une commande et/ou régulation (34) destinée à simuler un effondrement ou un court-circuit dans le réseau d'alimentation en énergie, où, d'une part, le circuit convertisseur (29) est influencé de façon coordonnée dans le temps, de telle sorte que la tension (Vpcc) au point de connexion (P) passe à une première valeur souhaitée, et, d'autre part, le premier interrupteur (32) est fermé, de telle sorte que le passage à l'effondrement ou au court-circuit recherché du réseau d'alimentation en énergie présente l'évolution souhaitée; ou arrêt d'un effondrement ou d'un court-circuit simulé dans le réseau d'alimentation en énergie, par le fait que, d'une part, le circuit convertisseur (29) est influencé de façon coordonnée dans le temps, de telle sorte que la tension (Vpcc) au point de connexion (P) passe à une deuxième valeur souhaitée et le premier interrupteur est ouvert.

6. Circuit (40) selon la revendication 5, dans lequel il est prévu un montage en parallèle qui est constitué d'une bobine d'inductance (42) et d'un deuxième interrupteur (43) et qui est connecté entre le circuit convertisseur (29) et le point de connexion (P), et dans lequel, au cours d'un effondrement ou d'un court-circuit simulé dans le réseau d'alimentation en énergie, le deuxième interrupteur (43) est ouvert par la commande et/ou régulation (34) de façon coordonnée dans le temps avec le circuit convertisseur (29) et la fermeture du premier interrupteur (32).

7. Circuit (40) selon la revendication 5, dans lequel il est prévu un montage en parallèle qui est constitué d'une bobine d'inductance (42) et d'un deuxième interrupteur (43) et qui est connecté entre le circuit convertisseur (29) et le point de connexion (P), et dans lequel, au cours d'un arrêt d'un effondrement ou d'un court-circuit simulé dans le réseau d'alimentation en énergie, le deuxième interrupteur (43) est fermé par la commande et/ou régulation (34) de façon coordonnée dans le temps avec le circuit convertisseur (29) et l'ouverture du premier interrupteur (32).

8. Circuit (10, 40) selon l'une quelconque des revendications 5 à 7, dans lequel le/les interrupteur(s) (32, 43) est/sont réalisé(s) en tant que composant(s) semi-conducteur(s) de puissance électronique(s), par exemple en tant que thyristor avec ou sans circuit d'extinction associé ou en tant que thyristor GTO (GTO = gate-turn-off) ou en tant que transistor IGBT blocable (IGBT = insulated gate bipolar transistor).

9. Circuit (10, 40) selon l'une quelconque des revendications 5 à 8, dans lequel l'inductance/les inductances de la/des bobine(s) d'inductance (31, 42) est/sont réglable(s).

10. Circuit (10, 40) selon l'une quelconque des revendications 5 à 9, dans lequel il est prévu un circuit de filtrage (33) qui est relié au point de connexion (P).

11. Circuit (10, 40) selon l'une quelconque des revendications 5 à 10, dans lequel il est prévu, en tant que générateur d'énergie, un générateur asynchrone (13) ou un générateur synchrone, le cas échéant avec des convertisseurs (14) associés.

12. Circuit (10, 40) selon l'une quelconque des revendications 5 à 11, dans lequel le générateur d'énergie est prévu pour une utilisation dans une éolienne.

13. Circuit (10, 40) selon la revendication 12, dans lequel il existe une simulation de vent (17) qui présente un moteur électrique (21), lequel est couplé de manière solidaire en rotation au générateur d'énergie.

14. Circuit (10, 40) selon la revendication 13, dans lequel le générateur d'énergie n'est pas encore monté dans l'éolienne.
